# EUROPEAN PATENT SPECIFICATION

(11) **EP 2 555 600 B1**
(45) Date of publication and mention of the grant of the patent: **23.05.2018**
(21) Application number: 11176064.1
(22) Date of filing: 30.07.2011
(51) Int. Cl.: H05K 1/14, H01R 12/73, H01R 12/70

(54) **A PCB arrangement**
PCB-Anordnung
Agencement de carte à circuit imprimé

(43) Date of publication of application: 06.02.2013
(73) Proprietor: Advanced Digital Broadcast S.A., 1292 Chambesy (CH)
(72) Inventor: Paczkowski, Jacek, 65-119 Zielona Gora (PL)
(74) Representative: Kancelaria Eupatent.pl Sp. z.o.o

(56) References cited:
- DE-A1-102007 039 618
- GB-A- 2 251 128
- JP-A- 7 321 152
- US-A- 5 263 868
- US-A- 6 109 927
- US-A1- 2010 134 995

## Description

The present invention relates to an arrangement of printed circuit boards (PCB) wherein two boards are interconnected.

Modern electronic devices use electronic components of different complexity. On the one hand, sophisticated integrated circuit chips, such as signal processors operating at high frequencies with dozens or hundreds of input/output (I/O) lines are used, which require complicated routing of circuit paths. Such sophisticated chips have to be mounted on multi-layer PCBs, which are expensive and complicated to manufacture. On the other hand, simple devices such as power supply modules or low-speed input/output connectors are used, which require only a few signal path connections and can be mounted on single- or double-layer PCBs. So far, all devices have been usually mounted on a common circuit board. Such approach is not efficient, as the use of a multi-layer PCB for simple devices is not necessary.

There are known PCB arrangements in which two PCBs are coupled together. For example, a US patent application US20100134995A1 presents an electrical interconnection system comprising a pair of printed wiring boards have surfaces operable to be placed adjacent to one another such that an electrical circuit coupled to one printed wiring board is electrically coupled to another electrical circuit of the other printed wiring board by contact of the surface pads of each printing wiring board with one another. Such boards are relatively hard to manufacture and use dedicated, non-standard pads on the board. US patent application US5263868A1 discloses a printed circuit board arrangement according to the preamble of claim 1. US patent application US6109927A1 discloses a printed circuit board assembly with non-overlapping printed circuit boards with a connector comprising a slotted main frame configured to receive in the slots contact members for contacting circuit paths on the circuit boards. The aim of the present invention is to provide an alternative PCB arrangement for interconnecting two boards, which allows manufacturing the PCBs in a standard technology.

The object of the invention is a printed circuit board (PCB) arrangement, comprising a first PCB with circuit paths on a top plane, a second PCB with circuit paths on a top plane, partially overlapping the first PCB in an overlap area, wherein each of the first PCB and the second PCB comprises at least one opening situated within the overlap area such that the openings define a passage from the top plane of the second PCB to the bottom plane of the first PCB, wherein a connector is mounted on the top plane of the second PCB by means of at least one fastening element extending through the passage defined by the openings and fixed to the bottom plane of the first PCB, the connector comprising a plurality of contact members electrically coupled with the circuit paths of the top planes of the first PCB and the second PCB, characterized in that the connector comprises a slotted main frame configured to receive in the slots contact members having end portions for contacting the circuit path and resiliently movable with respect to a middle portion held between the slotted main frame and a bottom part of the connector, wherein the slots provide clearance for resilient deformation of the contact members within the main frame and wherein the clearance between the bottom part and the main frame of the connector is larger than the middle portion of the connector to allow for tilting of the middle portion of the contact members. Preferably, the first PCB comprises a plurality of openings, which are coaxial with corresponding openings of the second PCB and the connector comprises a plurality of fastening elements extending through the passages defined by the openings.

Preferably, within the overlap area the first PCB and the second PCB have complementary stepped edges.

Preferably, the top plane of the first PCB is coplanar with the top plane of the second PCB.

Preferably, the top planes of the first PCB and of the second PCB are parallel and not coplanar.

Preferably, the contact members are made of resilient material.

Preferably, the fastening elements are snap-type fasteners permanently fixed to the connector.

Preferably, the connector comprises means for attaching of fastening elements separate from the connector.

Preferably, the contact members and the circuit paths are made of or coated by non-oxidising metal.

Preferably, the PCB arrangement further comprises a connector mounted on the bottom plane of the first PCB by means of the pair of the fastening elements of the connector mounted on the top plane of the second PCB.

The object of the invention is also an electronic device comprising the PCB arrangement according to the invention.

The PCB arrangement according to the invention allows precise positioning of the PCBs, the connector and the circuit paths, by providing coaxial openings in the edge area of the PCBs, through which the fasteners coupled to the connector pass. This automatically positions all elements of the arrangement precisely with respect to each other. By providing resilient contact members, the arrangement is prone to vibrations and tolerant to dimensional imprecision of the PCBs. Due to contact-only connection, the connector can be easily decoupled and coupled to the PCB, without the need for soldering or other coupling, which allows easy mounting of the arrangement at the assembly stage and easy disassembly e.g. for servicing purposes. One of the PCBs may comprise electronic elements requiring complicated, multi-layer circuit paths or electronic elements operating with a high frequency, while the other PCB may comprise electronic elements requiring simple, single- or double-layer circuit paths or electronic elements operating with a low frequency.

The object of the invention is shown by means of an exemplary embodiments on a drawing, in which:
Figs. 1-2 show an exploded and assembled view of one embodiment of the PCB arrangement,
Fig. 3 shows an assembled view of another embodiment of the PCB arrangement,
Fig. 4 shows an assembled view of yet another embodiment of the PCB arrangement,
Figs. 5-6 show one embodiment of the connector in a perspective and cross-sectional view,
Fig. 7 shows another embodiment of the connector in an exploded view,

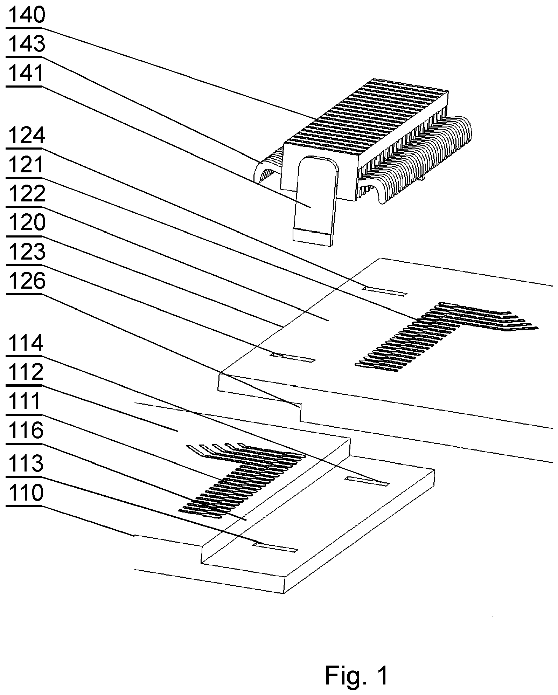

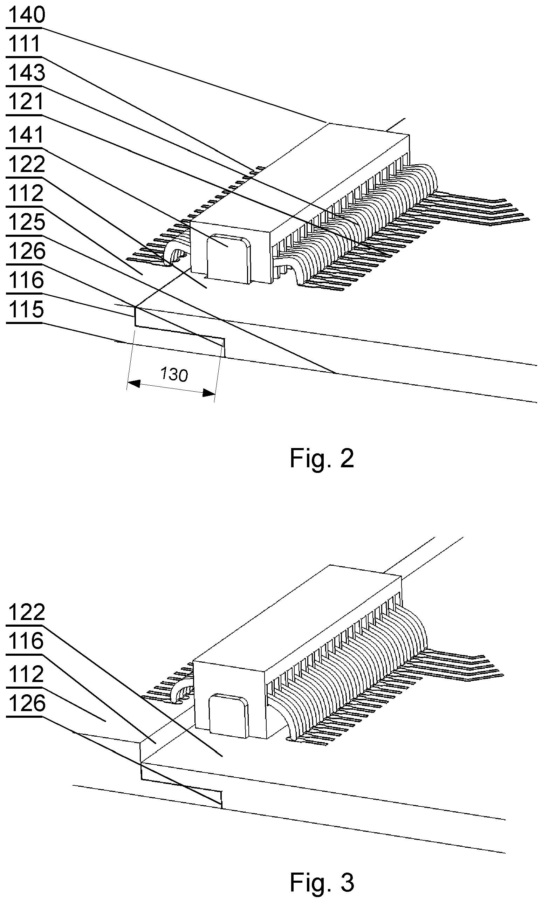

The PCB arrangement according to the invention, shown in an exemplary embodiment in an exploded and assembled views on Figs. 1-2, comprises a first printed circuit board (PCB) 110 and a second PCB 120 which are arranged in a partially overlapping manner. The PCBs 110, 120 have circuit paths 111, 121 on their top planes 112, 122. The circuit paths 111, 121 guide electric signal to electric components mounted on the board. Preferably, one of the boards 110, 120 has more layers than the other board 110, 120, i.e. a board with a smaller degree of complexity is connected with a board of a higher degree of complexity. The area within which the boards 110, 120 overlap is designated as an overlap area 130. Within the overlap area 130, the first board 110 and the second board 120 have complementary stepped edges 116, 126. The edges of the boards within the overlap area 130 may be also shaped in a different manner, for example they can be chamfered. In the simplest embodiment, the edges may be straight and the boards 110, 120 may be overlaid one on another, which results that both the top surfaces 112, 122 and the bottom surfaces 115, 125 are parallel but not coplanar. The top planes 112, 122 of the boards may be coplanar as shown in the embodiment of Figs. 1-2 or parallel, but not coplanar, as shown in another embodiment of Fig. 3. Within the overlap area 130, the boards 110, 120 comprise at least a pair of coaxial openings 113-123, 114-124. A connector 140 is mounted on the top plane 122 of the second PCB 120 by means of at least a pair of fastening elements 141, 142. The fastening elements 141, 142 extend through the coaxial openings 113-123, 114-124 and are fixed to the bottom plane 115 of the first PCB. Furthermore, the connector 140 comprises a plurality of contact members 143, which are electrically coupled with the circuit paths 111, 121.

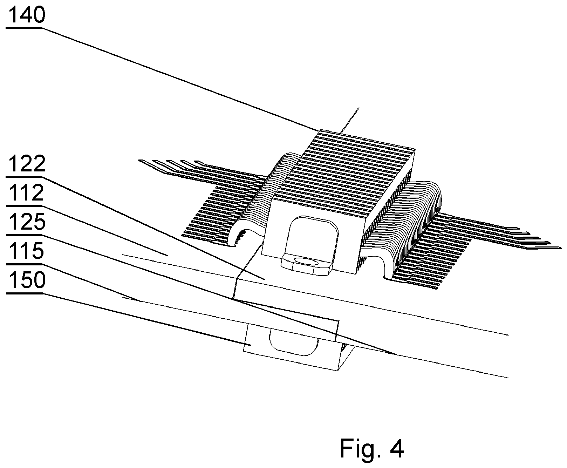

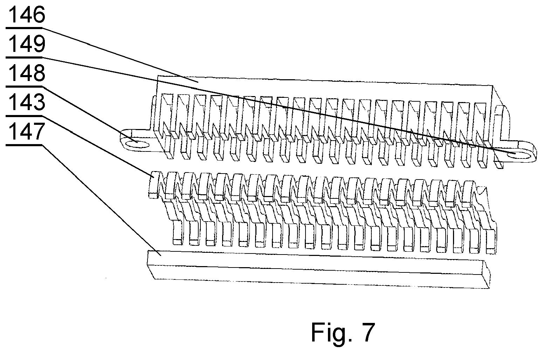

The PCB arrangement, as shown in yet another embodiment on Fig. 4, may further comprise a second connector 150, mounted on the bottom plane 115 of the first PCB 110 for connecting the circuit paths routed at the bottom planes 115, 125 and having fastening elements common with the first connector 140 and extending through the same coaxial openings 113-123, 114-124 in the first PCB 110 and in the second PCB 120. In that case, the connectors 140, 150 can be configured according to the embodiment shown in Fig. 7 and the fastening elements may be screws joining the openings in the connectors.

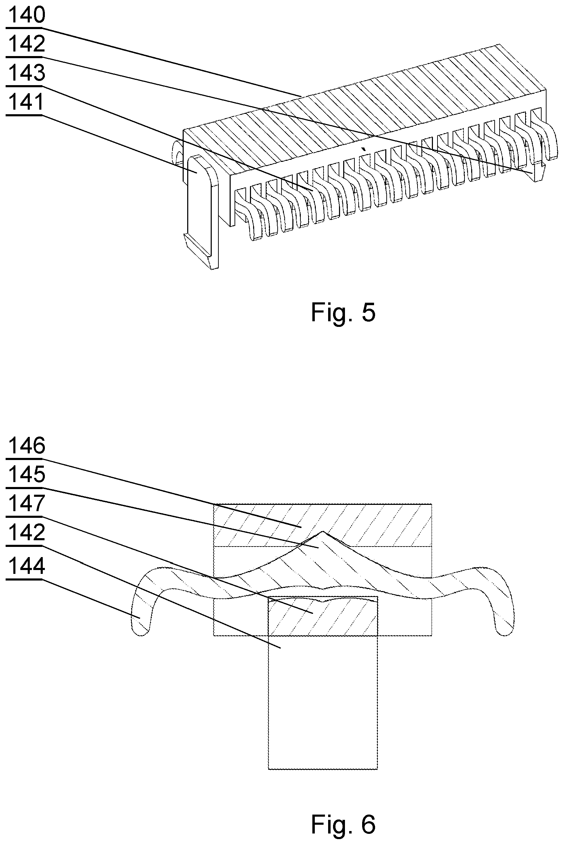

The connector, as shown in one embodiment in a perspective and cross-sectional view in Figs. 5-6, has contact members 143 which have a first portion 144 for contacting the circuit path 111, 121 and a second portion 145 mechanically connected with the connector frame 146, wherein the first portion 144 is resiliently movable with respect to the second portion 145. The contact members 143 can be made of a resilient material, such as phosphor bronze or beryllium bronze. The contact members 143 and the circuit paths 111, 121 can be made of or coated by non-oxidizing metal, such as gold, which guarantees good conductivity while the PCB arrangement is in use. When the connector is fastened to the board, the resiliency of the contact members 143 compensates any irregularities of the assembly and guarantees constant contact of the members 143 and the circuit paths. Moreover, it allows to keep the contact even when the PCB arrangement is inclined or turned upside-down. The first portion 144 has a rounded edge so that contact with the circuit path is guaranteed. For more secure contact, the first portion 144 can be soldered to the circuit paths 111, 121.

The connector may comprise a slotted main frame 146 to which the contact members 143 are mounted and a bottom part 147 which holds the contact members 143 in place.

The fastening elements 141, 142 can be snap-type fasteners permanently fixed to the connector 140, for example to its main frame 146 as shown in Fig. 5. In another embodiment, as shown in Fig. 7, the fastening elements can be separate from the connector 140, and the connector may comprise means for attaching the fastening elements, for example openings 148, 149 for screws.

The terms "top plane" and "bottom plane" as used throughout the description and claims are meant to clearly differentiate between two opposite planes of the PCB. It is evident that the actual orientation of these planes in the PCB arrangement will be defined by the orientation of the PCB arrangement as a whole or as mounted in an electronic device, and the PCB arrangement can be mounted with its top plane pointing upwards, downwards or inclined with respect to the horizontal line.

## Claims

1. A printed circuit board (PCB) arrangement, comprising:
- a first PCB (110) with circuit paths (111) on a top plane (112),
- a second PCB (120) with circuit paths (121) on a top plane (122), partially overlapping the first PCB (110) in an overlap area (130),
- wherein each of the first PCB (110) and the second PCB (120) comprises at least one opening (113-123, 114-124) situated within the overlap area (130) such that the openings (113-123, 114-124) define a passage from the top plane (122) of the second PCB (120) to the bottom plane (115) of the first PCB (110),
- wherein a connector (140) is mounted on the top plane (122) of the second PCB (120) by means of at least one fastening element (141, 142) extending through the passage defined by the openings (113-123, 114-124) and fixed to the bottom plane (115) of the first PCB, the connector (140) comprising a plurality of contact members (143) electrically coupled with the circuit paths (111, 121) of the top planes (112, 122) of the first PCB (110) and the second PCB (120).
**characterized in that**
- the connector comprises a slotted main frame (146) configured to receive in the slots contact members (143) having end portions (144) for contacting the circuit path (111, 121) and resiliently movable with respect to a middle portion (145) held between the slotted main frame (146) and a bottom part (147) of the connector, wherein the slots provide clearance for resilient deformation of the contact members (143) within the main frame (146) and wherein the clearance between the bottom part (147) and the main frame (146) of the connector is larger than the middle portion (145) of the connector to allow for tilting of the middle portion (145) of the contact members (143).

2. The PCB arrangement according to claim 1, wherein the first PCB (110) comprises a plurality of openings (113, 114), which are coaxial with corresponding openings (123, 124) of the second PCB (120) and the connector (140) comprises a plurality of fastening elements (141, 142) extending through the passages defined by the openings (113-123, 114-124).

3. The PCB arrangement according to any of claims 1-2, wherein within the overlap area (130) the first PCB (110) and the second PCB (120) have complementary stepped edges (116, 126).

4. The PCB arrangement according to any of previous claims, wherein the top plane (112) of the first PCB (110) is coplanar with the top plane (122) of the second PCB (120).

5. The PCB arrangement according to any of claims 1-3, wherein the top planes (112, 122) of the first PCB (110) and of the second PCB (120) are parallel and not coplanar.

6. The PCB arrangement according to any of previous claims, wherein the contact members (143) are made of resilient material.

7. The PCB arrangement according to any of previous claims, wherein the fastening elements (141, 142) are snap-type fasteners permanently fixed to the connector (140).

8. The PCB arrangement according to any of previous claims, wherein the connector comprises means (148, 149) for attaching of fastening elements separate from the connector (140).

9. The PCB arrangement according to any of previous claims, wherein the contact members (143) and the circuit paths (111, 121) are made of or coated by non-oxidising metal.

10. The PCB arrangement according to any of previous claims, further comprising a connector (150) mounted on the bottom plane (115) of the first PCB (110) by means of the pair of the fastening elements (141, 142) of the connector (140) mounted on the top plane (122) of the second PCB (120).

11. An electronic device comprising the PCB arrangement according to any of previous claims.

## Patentansprüche

1. Leiterplatten-Anordnung (printed circuit board, PCB, arrangement), die Folgendes umfasst:
- eine erste PCB (110) mit Leiterbahnen (111) auf einer oberen Ebene (112),
- eine zweite PCB (120) mit Leiterbahnen (121) auf einer oberen Ebene (122), die die erste PCB (110) in einem Überlappungsbereich (130) zum Teil überlappt,
- wobei jede der ersten PCB (110) und der zweiten PCB (120) mindestens eine Öffnung (113-123, 114-124) umfasst, die sich im Überlappungsbereich (130) befindet, so dass die Öffnungen (113-123, 114-124) einen Kanal von der oberen Ebene (122) der zweiten PCB (120) zur unteren Ebene (115) der ersten PCB (110) definieren,
- wobei ein Verbinder (140) auf der oberen Ebene (122) der zweiten PCB (120) montiert ist mittels mindestens einem Befestigungselements (141, 142), das sich durch den durch die Öffnungen (113-123, 114-124) definierten Kanal erstreckt und das an die untere Ebene (115) der ersten PCB fixiert ist, wobei der Verbinder (140) eine Vielzahl von Kontaktgliedern (143) umfasst, die mit den Leiterbahnen (111) der oberen Ebenen (112, 122) der ersten PCB (110) und der zweiten PCB (120) elektrisch gekoppelt ist
**dadurch gekennzeichnet, dass**
- der Verbinder einen geschlitzten Hauptrahmen (146) umfasst, der konfiguriert ist, um in den Schlitzen Kontaktglieder (143) aufzunehmen, die Endabschnitte (144) aufweisen, um die Leiterbahn (111, 121) zu kontaktieren, und in Bezug auf einen mittleren Abschnitt (145) elastisch bewegbar ist, der zwischen dem geschlitzten Hauptrahmen (146) und einem unteren Teil (147) des Verbinders gehalten wird, wobei die Schlitze Spiel für elastische Verformung der Kontaktglieder (143) im Hauptrahmen (146) bereitstellen und wobei das Spiel zwischen dem unteren Teil (147) und dem Hauptrahmen (146) des Verbinders größer als der mittlere Abschnitt (145) des Verbinders ist, um Neigung des mittleren Abschnitts (145) der Kontaktglieder (143) zuzulassen.

2. PCB-Anordnung nach Anspruch 1, wobei die erste PCB (110) eine Vielzahl von Öffnung (113, 114) umfasst, die koaxial zu entsprechenden Öffnungen (123, 124) der zweiten PCB (120) sind und der Verbinder (140) eine Vielzahl von Befestigungselementen (141, 142) umfasst, die sich durch die durch die Öffnungen (113-123, 114-124) definierten Kanäle erstrecken.

3. PCB-Anordnung nach einem der Ansprüche 1-2, wobei im Überlappungsbereich (130) die erste PCB (110) und die zweite PCB (120) komplementäre abgestufte Ränder (116, 126) aufweisen.

4. PCB-Anordnung nach einem der vorhergehenden Ansprüche, wobei die oberste Ebene (112) der ersten PCB (110) koplanar zur oberen Ebene (122) der zweiten PCB (120) ist.

5. PCB-Anordnung nach einem der Ansprüche 1-3, wobei die oberen Ebenen (112, 122) der ersten PCB (110) und der zweiten PCB (120) parallel sind und nicht koplanar.

6. PCB-Anordnung nach einem der vorhergehenden Ansprüche, wobei die Kontaktglieder (143) aus elastischem Material hergestellt sind.

7. PCB-Anordnung nach einem der vorhergehenden Ansprüche, wobei die Befestigungselemente (141, 142) Schnapp-Befestiger sind, die permanent am Verbinder (140) fixiert sind.

8. PCB-Anordnung nach einem der vorhergehenden Ansprüche, wobei der Verbinder Mittel (148, 149) umfasst, um Befestigungselemente getrennt vom Verbinder (140) anzubringen.

9. PCB-Anordnung nach einem der vorhergehenden Ansprüche, wobei die Kontaktglieder (143) und die Leiterbahnen (111, 121) aus nichtoxidierendem Metall hergestellt oder damit beschichtet sind.

10. PCB-Anordnung nach einem der vorhergehenden Ansprüche, die ferner einen Verbinder (150) umfasst, der auf der unteren Ebene (115) der ersten PCB (110) durch ein Paar der Befestigungselemente (141, 142) des Verbinders (140) montiert ist, der auf der oberen Ebene (122) der zweiten PCB (120) montiert ist.

11. Elektronische Vorrichtung, die die PCB-Anordnung nach einem der vorhergehenden Ansprüche umfasst.

## Revendications

1. Agencement de cartes de circuit imprimé (PCB), comprenant :
- une première PCB (110) présentant des tracés de circuit (111) sur un plan supérieur (112),
- une seconde PCB (120) présentant des tracés de circuit (121) sur un plan supérieur (122), partiellement superposée à la première PCB (110) sur une zone de chevauchement (130),
- chacune de la première PCB (110) et de la seconde PCB (120) comprenant au moins une ouverture (113-123, 114-124) située dans la zone de chevauchement (130) de sorte que les ouvertures (113-123, 114-124) définissent un passage à partir du plan supérieur (122) de la seconde PCB (120) jusqu'au plan inférieur (115) de la première PCB (110),
- un connecteur (140) étant monté sur le plan supérieur (122) de la seconde PCB (120) au moyen d'au moins un élément de fixation (141, 142) s'étendant à travers le passage défini par les ouvertures (113-123, 114-124) et fixé au plan inférieur (115) de la première PCB, ledit connecteur (140) comprenant une pluralité d'éléments de contact (143) couplés électriquement avec les tracés de circuit (111, 121) des plans supérieurs (112, 122) de la première PCB (110) et de la seconde PCB (120),
**caractérisé en ce que**
- le connecteur comprenant une armature principale à fentes (146) conçue pour recevoir dans les fentes des éléments de contact (143) possédant des parties d'extrémité (144) destinées à être en contact avec le tracé de circuit (111, 121) et mobiles élastiquement par rapport à une partie médiane (145) maintenue entre l'armature principale à fentes (146) et une partie inférieure (147) du connecteur, lesdites fentes fournissent un jeu pour la déformation élastique des éléments de contact (143) dans l'armature principale (146) et ledit jeu entre la partie inférieure (147) et l'armature principale (146) du connecteur étant plus grand que la partie médiane (145) du connecteur pour permettre l'inclinaison de la partie médiane (145) des éléments de contact (143).

2. Agencement de PCB selon la revendication 1, ladite première PCB (110) comprenant une pluralité d'ouvertures (113, 114), qui sont coaxiales avec des ouvertures correspondantes (123, 124) de la seconde PCB (120) et le connecteur (140) comprenant une pluralité d'éléments de fixation (141, 142) s'étendant travers les passages définis par les ouvertures (113-123, 114-124).

3. Agencement de PCB selon l'une quelconque des revendications 1 à 2, dans la zone de chevauchement (130) ladite première PCB (110) et ladite seconde PCB (120) possédant des bords étagés complémentaires (116, 126).

4. Agencement de PCB selon l'une quelconque des revendications précédentes, ledit plan supérieur (112) de la première PCB (110) étant coplanaire avec le plan supérieur (122) de la seconde PCB (120).

5. Agencement de PCB selon l'une quelconque des revendications 1 à 3, lesdits plans supérieurs (112, 122) de la première PCB (110) et de la seconde PCB (120) étant parallèles et non coplanaires.

6. Agencement de PCB selon l'une quelconque des revendications précédentes, lesdits éléments de contact (143) étant constitués de matériau élastique.

7. Agencement de PCB selon l'une quelconque des revendications précédentes, lesdits éléments de fixation (141, 142) étant des fixations de type encliquetable fixées de façon permanente au connecteur (140).

8. Agencement de PCB selon l'une quelconque des revendications précédentes, ledit connecteur comprenant des moyens (148, 149) destinés à attacher des éléments de fixation distincts du connecteur (140).

9. Agencement de PCB selon l'une quelconque des revendications précédentes, lesdits éléments de contact (143) et lesdits tracés de circuit (111, 121) étant constitués ou revêtus de métal non oxydant.

10. Agencement de PCB selon l'une quelconque des revendications précédentes, comprenant en outre un connecteur (150) monté sur le plan inférieur (115) de la première PCB (110) au moyen de la paire d'éléments de fixation (141, 142) du connecteur (140) monté sur le plan supérieur (122) de la seconde PCB (120).

11. Dispositif électronique comprenant l'agencement de PCB selon l'une quelconque des revendications précédentes.
